(19) Europäisches Patentamt
European Patent Office
Office européen des brevets

(11) Publication number: 0 097 370 B2

(12) NEW EUROPEAN PATENT SPECIFICATION

(45) Date of publication of the new patent specification: 02.05.91 Bulletin 91/18

(51) Int. Cl.$^5$: C08L 81/06, H05K 1/02

(21) Application number: 83106076.9

(22) Date of filing: 22.06.83

# (54) Use of a composition for making circuit board substrates and electrical connectors.

(30) Priority: 23.06.82 US 391422

(43) Date of publication of application: 04.01.84 Bulletin 84/01

(45) Publication of the grant of the patent: 16.07.86 Bulletin 86/29

(45) Mention of the opposition decision: 02.05.91 Bulletin 91/18

(84) Designated Contracting States: AT BE CH DE FR GB IT LI LU NL SE

(56) References cited:
FR-A- 2 341 620
JP-A- 8 186 941
Patent Abstracts of Japan Vol. 6, no. 223, 9 November 1982

(56) References cited:
ELECTRONICS INTERNATIONAL, vol. 55, no. 5, 10 March 1982, New York, USA J. LYMAN "Thermoplastics take to the boards", pages 105-106
CHEMICAL ABSTRACTS, Vol. 95, 1981, Ref. 95: 188309w
CAS CHEMISTRY HANDBOOK, Numbers 25 135-51-7 and 25 667-42-9

(73) Proprietor: AMOCO CORPORATION
200 East Randolph Drive P.O. Box 5910-A
Chicago Illinois 60680 (US)

(72) Inventor: Harris, James Elmer
211 Birchview Drive
Piscataway New Jersey 08854 (US)
Inventor: Robeson, Lloyd Mahlon
R.D. 1, Box 244
Whitehouse Station New Jersey 08889 (US)

(74) Representative: Weinhold, Peter, Dr. et al
Patentanwälte Dr. V. Schmied-Kowarzik
Dipl.-Ing. G. Dannenberg Dr. P. Weinhold Dr. D. Gudel Dipl.-Ing. S. Schubert Dr. P. Barz
Siegfriedstrasse 8
W-8000 München 40 (DE)

EP 0 097 370 B2

## Description

### Background on the Invention

This invention is directed to the use of a composition useful for making circuit board substrates and electrical connectors comprising a blend of a poly(ether sulfone) and polysulfone. Additionally this invention relates to a circuit board substrate and electrical connector made from such a blend.

JP-A-81/86941, according to the abstract n° 188 309 w in Chemical Abstracts volume 95,1981, page 49 discloses that blends of polysulfones with polyether-polysulfones are useful for the manufacture of multiporous hollow fibers with improved water permeability.

U.S. Patent 4,281,038 describes a non-conductive substrate (board) for a printed circuit made from a thermoplastic selected from polyphenyloxide, polyphenylsulfide, polyimide and polyethersulfone. The thermoplastic has dispersed therein discrete particles of a material such as iron, copper, compounds of iron and compounds of copper which have a coating of a bonding assistant such as a silicone resin, an organic silane and a silane ester.

Circuit boards are widely used in the electrical industry for radio, television, computers, appliances, industrial and electronic equipment. Printed circuit boards have been traditionally manufactured from a copper clad epoxy-glass laminate. When starting with this material the shape of the printed circuit board must first be routed out and the holes for mounting the components (e.g., transistors, resistors, integrated circuits, etc.) individually drilled. The board is then masked with photoresist, the circuitry imaged and the copper etched away from areas where it is not wanted. An alternative to this procedure is to injection mold the circuit board substrate with the holes in place. The molded substrate is then put through several adhesion promotion steps and plated with electroless copper according to standard technology, to produce the printed circuit board. In this case the substrate material is limited to thermoplastic resins with sufficient thermal stability and chemical properties to survive wave soldering. Also, savings may result with these injection molded circuit board substrates due to the elimination of considerable mechanical processing such as routing and drilling.

The critical parameters of a printed circuit board, from a soldering standpoint, are its heat distortion temperature, environmental stress crack resistance and thermal expansion coefficient. The higher a substrate's heat distortion temperature and environmental stress crack resistance to solder fluxes, the less likely it will blister or delaminate during soldering.

When a polysulfone based on bisphenol A is molded into a circuit board substrate it has a heat distortion temperature which is generally too low for soldering temperatures such as those encountered in wave soldering. A circuit board substrate molded from poly(ether sulfone) is resistant to specific etching solutions (e.g., chromic acid) and is thus harder to prepare suitable surfaces for plating. Additionally, circuit boards molded from poly(ether sulfone) do not have, in many instances, acceptable plateability. Acceptable plateability requires good adhesion of electrolessly plated copper to the substrate.

### Description of the Invention

It has now been found that when a polysulfone is added to a poly(ether sulfone), a circuit board substrate molded from the resultant composition has improved plateability. The combination of polysulfone and poly(ether sulfone) yields adequate heat distortion temperatures and susceptibility to chromic acid etching such that the combination performs better than the individual components in molding circuit board substrates.

The composition used for making circuit board substrates and electrical connectors comprises from 40 to 90, preferably from 50 to 85, weight percent of a poly(ether sulfone) and from 10 to 60. preferably from 15 to 50, weight percent of polysulfone.

The poly(ether sulfone) suitable for use in this invention include homopolymers, co- and higher polymers having repeating units of the following formula :

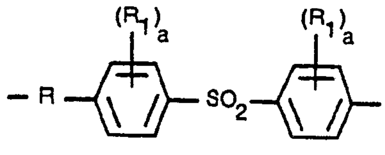

wherein R is selected from O and S, each $R_1$ is independently hydrogen, a halogen atom, an alkyl group of from 1 to 4 carbon atoms and an alkoxy group from 1 to 4 carbon atoms, i.e. methyl-, ethyl-, propyl-, butyl-groups (straight or branched) and corresponding -oxy-groups and a is an integer of 0 ; 1 ; 2 ; 3 or 4. Preferably, the

poly(ether sulfone) has repeating units of the following formula :

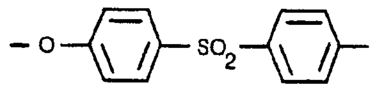

These polymers are well known in the art and are described in, for example, U.S. Patents 4,175,175 and 4,008,203.

A preferred copolymer contains units of the following formula :

(I) 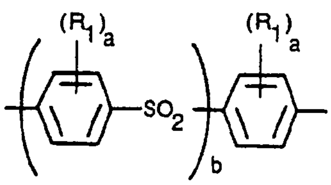 and (II) 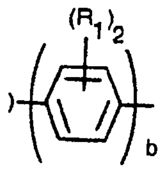

wherein $R_1$ and a are defined as above, and b is independently an integer of 1 ; 2 or 3. The ratio of unit (I) to unit (II) is preferably greater than 1. Units (I) and (II) are attached to each other by an –O– bond.

The preferred copolymer contains units of the formula

(I) 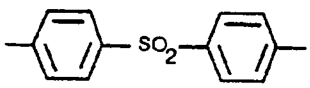 , and (II) 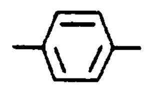

The polysulfone suitable for use in this invention includes homopolymers and co- and higher polymers having repeating units of the following formula :

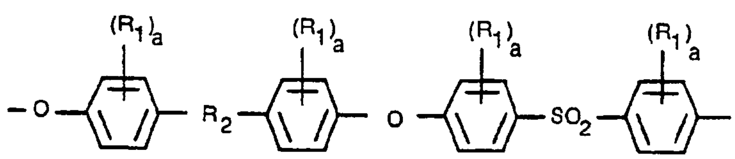

wherein $R_1$ and a are defined as above and $R_2$ is a bond between aromatic carbon atoms or a divalent connecting radical of the formula :

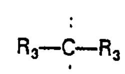

wherein $R_3$ is independently selected from $C_1$-$C_4$-alkyl, aryl, preferably phenyl and halogen substituted groups thereof. Preferably the polysulfone has repeating units of the formula :

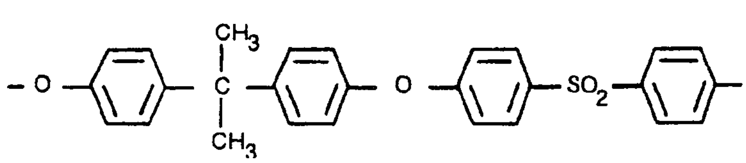

These polymers are well known in the art and are described in, for example, U.S. Patent 4,175,175.

The composition may contain other ingredients such as stabilizers, i.e., metal oxides such as zinc oxide, antioxidants, flame retardants, pigments, fibers and inorganic fillers. Preferably, the composition contains fibers and/or inorganic fillers.

The reinforcing fiber includes fiberglass, carbon fibers, and the like, and mixtures thereof. The particulate inorganic fillers which may be used include wollastonite, calcium carbonate, glass beads, talc and mica, or mixtures thereof.

The fiber reinforcement, filler or combinations thereof, is utilized in amounts of from 0 to 50 weight percent, preferably from 10 to 35 weight percent.

The compositions this invention are prepared by any conventional mixing methods. For example, a preferred method comprises mixing the poly(ether sulfone) used in polysulfone and other optional ingredients in powder or granular form in an extruder and extruding the mixture into strands, chopping the strands into the desired circuit board substrate and electrical connector.

The composition used in this invention can be molded into circuit board substrates and electrical connectors using conventional techniques. Specifically, the composition can be molded into circuit board substrates using conventional molding equipment. The molded boards are then swelled and etched to promote the adhesion of copper by both roughening the surface and introducing chemical moieties through oxidation. The circuitry is then applied to the board by either a conventional additive or a semiadditive process. In either case copper is applied to the substrate in an electroless manner after the application of catalysts which activate the surface to the deposition of metal in a conventional manner.

EXAMPLES

The following Examples serve to give specific illustrations of the practice of this invention but they are not intended in any way to limit the scope of this invention.

Control A

A polysulfone of the following formula

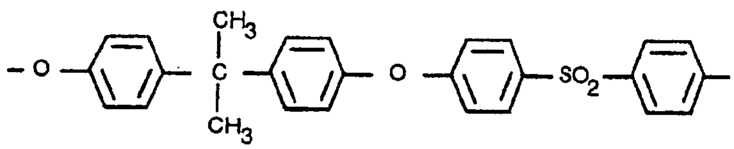

having a reduced viscosity of 0.43 as measured in chloroform (0.2 gram polymer in 100 ml at 25°C) was injection molded into ASTM test bars (at 270-300°C) using a Newburg 7 g (1/4 ounce) screw injection molding machine. The test bars were measured for the following properties : tensile strength and modulus according to ASTM D-638 ; elongation at break according to ASTM-638 ; notched izod impact strength according to ASTM D-256; tensile impact strength according to ASTM D-1822 ; heat distortion temperature measured at 1821 kPa (264 psi) on a 3.2 mm (1/8 inch) thick unannealed test bar according to ASTM D-638 ; melt flow according to ASTM D-1238-73 and pendulum impact strength according to the following procedures :

A sample 2.54 cm (one inch) long by 3.2 mm (one-eighth inch) wide 25-750 µm thick (1-30 mils thick) is mounted in the jaws such that it is transverse to the path of a pendulum and located at the bottom of the swing. The 3.2 mm (1/8 inch) face of the sample is impacted with the 6.4 mm (1/4 inch) diameter striking head of the pendulum. The pendulum is released from its starting position and allowed to swing through its cycle without a sample. The recovery height of zero energy loss is determined in this way. The cycle is repeated with a sample mounted inthe path of the pendulum. The recovery height is again determined. Since the breaking of the specimen extracted energy from the pendulum, the same recovery height is not attained. The difference in the recovery height (i.e., the difference in the potential energy of the pendulum at the maximum point of the upswing) represents the energy absorbed by the specimen during rupture. The impact strength, expressed in Nm per cm3 (foot-pounds per cubic inch) is obtained by dividing the pendulum energy loss by the volume of the specimen. Five to ten specimens are tested for each material. The results are as shown in Table I.

Control B

A poly(ether sulfone) of the following formula

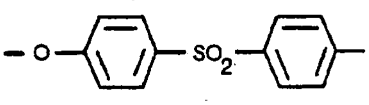

having a reduced viscosity of 0.48 (as meassured) in N-methyl pyrrolidone at 25°C) was injection molded into

ASTM test bars and tested as described in Control A.

The results are shown in Table I.

Example 1

A blend of 90 weight percent of the poly(ether sulfone) of Control B and 10 weight percent of the polysulfone of Control A was prepared by extrusion blending in a single screw 2.54 cm (1 -inch) diameter extruder with L/D = 36/1 at 300-320°C.

The extrudate was chopped into pellets. The pellets were injection molded into ASTM test bars and tested as described in Control A.

The results are shown in Table I.

Example 2

The procedure of Example 1 was exactly repeated except that 70 weight percent of the poly(ether sulfone) of Control B and 30 weight percent of the polysulfone of Control A were used.

The results are shown in Table I.

Example 3

The procedure of Example 1 was exactly repeated except that 50 weight percent of the poly(ether suylfone) of Control B and 50 weight percent of the polysulfone of Control A were used.

The results are shown in Table I.

Control C

The procedure of Example 1 was exactly repeated except that 30 weight percent of the poly(ether sulfone) of Control B and 70 weight percent of the polysulfone of Control A were used.

The result are shown in Table I.

TABLE I

| Description of the Composition | Polymer[1] | (wt %) | Tensile Modulus MPa (psi) | Tensile Strength Mpa (psi) | Elongation (%) | Notched Izod Impact Strength Nm/cm of notch (ft-lbs/in of notch) | Tensile Impact Strength Nm/cm² ft-lbs/in²) | Heat Distortion Temperature (°C) | Pendulum Impact Strength Nm/cm³ (ft-lbs/in³) | $MF_{10}$ (350°C) 303 kPa (44 psi) dg/min | $MF_{10}$ (400°C) 303 kPa (44 psi) dg/min | $MF_{30}$ (40 4 |
|---|---|---|---|---|---|---|---|---|---|---|---|---|
| A | PS | (100) | 2552 (370,000) | 72.4 (10,500) | 70—100 | 0.64 (1.2) | 21—31.5 (100—150) | 168 | 13.6 (165) | 17 | | 0 |
| B | PES | (100) | 2683 (389.000) | 80.7 (11,700) | 88 | 0.85 (1.6) | 38.5 (183) | 201 | 13.7 (166) | 9.9 | | 0 |
| | PS<br>PES | (10)<br>(90) | 2710 (393,000) | 81.4 (11,800) | 104 | 0.96 (1.8) | 38.9 (185) | 198 | 11.7 (142) | 11.0 | 36.7 | 0 |
| | PS<br>PES | (30)<br>(70) | 2696 (391,000) | 79.3 (11,500) | 88 | 0.85 (1.6) | 38.0 (181) | 190 | 17.2 (208) | 13.8 | 36.1 | 0 |
| | PS<br>PES | (50)<br>(50) | 2738 (397,000) | 77.2 (11,200) | 93 | 0.75 (1.4) | 36.1 (172) | 183 | 12.9 (156) | 15.3 | 45.0 | 0 |
| C | PS<br>PES | (70)<br>(30) | 2779 (403,000) | 75.9 (11,000) | 80 | 0.70 (1.3) | 30.7 (148) | 182 | 11.1 (134) | 17.6 | 47.6 | 0 |

[1] PS = polysulfone
PES = poly(ether sulfone)

Control D

70 weight percent of the polysulfone of Control A was blended with 30 weight percent of fiberglass (OCF-197B made by Owens Corning Fiberglass) in a 2.54 cm (1-inch) extruder with L/D = 24/1 at about 300°C. The extrudate was chopped into pellets. The pellets were injection molded into ASTM test bars and tested for the following properties : tensile strength and modulus according to ASTM D-638 ; elongation at break according to ASTM D-638 ; notched izod impact strength according to ASTM D-256 ; tensile impact strength according to ASTM D-1822 and heat distortion temperature measured at 1821 kPa (264 psi) on a 3.2 mm (1/8 inch) thick unannealed test bar according to ASTM D-638.

The results are shown in Table II.

Control E

The procedure of Control D was exactly repeated except that 70 weight percent of the poly(ether sulfone) of Control B was blended with 30 weight percent of the fiberglass described in Control D.

The results are shown in Table II.

Example 4

The procedure of Control D was exactly repeated except that 50 weight percent of the poly(ether sulfone) of Control B was blended with 20 weight percent of the polysulfone of Control A and 30 weight percent of the fiberglass described in Control D.

The results are shown in Table II.

Example 5

The procedure of Control D was exactly repeated except that 40 weight percent of the poly(ether sulfone) of Control B was blended with 30 weight percent of the polysulfone of Control A and 30 weight percent of the fiberglass described in Control D.

The results are shown in Table II.

Example 6

The procedure of Control D was exactly repeated except that 35 weight percent of the polylether sulfone) of Control B was blended with 35 weight percent of the polysulfone of Control A and 30 weight percent of the fiberglass described in Control D.

The results are shown in Table II.

Control F

The procedure of Control D was exactly repeated except that 20 weight percent of the poly(ether sulfone) of Control B was blended with 50 weight percent of the polysulfone of Control A and 30 weight percent of the fiberglass described in Control D.

The results are shown in Table II.

TABLE II

| Example | Description of the Composition Ingredients[1] | (wt %) | Tensile Modulus MPa (psi) | Tensile Strength MPa (psi) | Elongation (%) | Notched Izod Impact Strength Nm/cm of notch (ft-lbs/in of notch) | Tensile Impact Strength Nm/cm$^2$ (ft-lbs/in$^2$) | Heat Distortion Temperature (°C) |
|---|---|---|---|---|---|---|---|---|
| Control D | PS | (70) | 8551 (1,240,000) | 123.4 (17,900) | 1.9 | 0.96 (1.8) | 14.5 (69) | 182 |
| | Fiberglass | (30) | | | | | | |
| Control E | PES | (70) | 7999 (1,160,000) | 129.0 (18,700) | 2.7 | 0.91 (1.7) | 20.4 (97) | 217 |
| | Fiberglass | (30) | | | | | | |
| 4 | PES | (50) | 8620 | 140.7 | | | | |
| | PS | (20) | (1,250,000) | (20,400) | 2.5 | 1.07 (2.0) | 19.5 (93) | 215 |
| | Fiberglass | (30) | | | | | | |
| 5 | PES | (40) | 9034 | 139.3 | | | | |
| | PS | (30) | (1,310,000) | (20,200) | 2.2 | 1.12 (2.1) | 17.0 (81) | 203 |
| | Fiberglass | (30) | | | | | | |
| 6 | PES | (35) | 9034 | 126.9 | | | | |
| | PS | (35) | (1,310,000) | (18,400) | 1.8 | 1.07 (2.0) | 22.1 (105) | 190 |
| | Fiberglass | (30) | | | | | | |
| Control F | PES | (20) | 8690 | 132.4 | | | | |
| | PS | (50) | (1,260,000) | (19,200) | 2.1 | 1.07 (2.0) | 15.5 (74)) | 185 |
| | Fiberglass | (30) | | | | | | |

[1] PS = polysulfone
PES = poly(ether sulfone)

The following Examples 7 to 9 describe blends of polysulfone, poly(ether sulfone), filler and/or reinforcing agent.

Example 7

40 weight percent of the polysulfone of Control A was blended with 30 weight percent of the poly(ether sulfone) of Control B and 30 weight percent of particulate wollastonite (Nyad N-400 sold by Nuco, a division of Processed Minerals, Inc. in an extruder with L/D equal to 24/1 at 300°C. The extrudate was chopped into pellets. The pellets were injection molded into ASTM test bars and tested as described in Control D.

The results are shown in Table III.

Example 8

The procedure of Example 7 was exactly repeated except that 35 weight percent of the polysulfone of Control A was blended with 35 weight percent of the poly(ether sulfone) of Control B and 30 weight percent of the Wollastonite described in Example 7.

The results are shown in Table III.

Example 9

The procedure of Example 7 was exactly repeated except that 27 weight percent of the polysulfone of Control A was blended with 41 weight percent of the poly(ether sulfone) of Control B, 15 weight percent of the Wollastonite described in Example 7, 15 weight percent of the fiberglass described in Control D and 2 weight percent of zinc oxide stabilizer.

The results are shown in Table III.

TABLE III

| Example | Description of the Composition Ingredients[1] | (wt %) | Tensile Modulus MPa (psi) | Tensile Strength MPa (psi) | Elon-gation (%) | Notched Izod Impact Strength Nm/cm of notch (ft-lbs/in of notch) | Tensile Impact Strength Nm/cm² (ft-lbs/in²) | Heat Distortion Temperature (°C) |
|---|---|---|---|---|---|---|---|---|
| 7 | PS | (40) | 4234 | 63.3 | | 0.53 | 6.1 | |
| | PES | (30) | (614,000) | (9,180) | 3.2 | (1.0) | (29) | 182 |
| | Wollastonite | (30) | | | | | | |
| 8 | PS | (35) | 4331 | 63.3 | | 0.48 | 5.3 | |
| | PES | (35) | (628,000) | (9,180) | 2.9 | (0.9) | (25) | 183 |
| | Wollastonite | (30) | | | | | | |
| 9 | PS | (27) | | | | | | |
| | PES | (41) | 6289 | 93.1 | | 0.64 | 2.7 | |
| | Wollastonite | (15) | (912,000) | (13,500) | 2.4 | (1.2) | (13) | 198 |
| | Fibreglass | (15) | | | | | | |
| | ZnO | (2) | | | | | | |

PS = polysulfone
PES = poly(ether sulfone)

## Control G

65 weight percent of the polysulfone of Control A was blended with 15 weight percent of the fiberglass of Control D, 18 weight percent of the wollastonite of Example 7 and 2 weight percent of zinc oxide stabilizer in a ZSK-53 Werner Pfleider twin screw extruder at 380°C. The extrudate was chopped into pellets. The material used for the circuit board was tested for the following properties ; tensile strength and modulus according to ASTM D-638 ; flexural strength and modulus according to ASTM D-790 ; elongation at break according to ASTM D-638 ; tensile impact strength according to ASTM D-1822 and the linear thermal expansion coefficient was measured according to ASTM D-696.

The results are shown in Table IV.

## Example 10

The procedure of Control G was exactly repeated except that 26.4 weight percent of the polysulfone of Control A, 40 weight percent of the poly(ether sulfone) of Control B, 15 weight percent of the fiberglass of Control D, 16.6 weight percent of the wollastonite of Example 7, and 2 weight percent of zinc oxide were used.

The results are shown in Table IV.

TABLE IV

| Example | Description of the Composition Ingredients[1] | (wt %) | Tensile Strength MPa (psi) | Tensile Modulus MPa (psi) | Flexural Strength MPa (psi) | Flexural Modulus MPa (psi) | Elongation (%) | Tensile Impact Strength $Nm/cm^2$ (ft-lb/sq in) | Linear Thermal Expansion Coeff. ($°C^{-1} \times 10^5$) |
|---|---|---|---|---|---|---|---|---|---|
| Control G | PS | (65) | 82.8 | 5379 | 131.7 | 5503 | | 4.2 | |
| | Fiberglass | (15) | (12,000) | (780,000) | (19,100) | (798,000) | 2.6 | (20) | 2.8 |
| | Wollastonite | (18) | | | | | | | |
| | ZnO | (2) | | | | | | | |
| 10 | PS | (26.4) | 96.6 | 6000 | 139.3 | 5793 | | 5.9 | |
| | PES | (40) | (14,000) | (870,000) | (20,200) | (840,000) | 2.5 | (28) | 2.8 |
| | Fiberglass | (15) | | | | | | | |
| | Wollastonite | (16.6) | | | | | | | |
| | ZnO | (2) | | | | | | | |

PS = polysulfone
PES = poly(ether sulfone)

Example 11

The materials of Control G and Example 10 were molded in an injection molding machine at 400°C into a circuit board 8.9 × 12.7 cm (31/2 × 5 inches.) The boards were then annealed at 168°C (335°C) for four hours followed by swell and etch steps to promote copper adhesion. These steps consisted of a dip in a solution of approximately 7 percent by weight water in N,N-dimethylformamide at 27°C (80°F) followed by a water rinse, then dipping in chromosulfuric acid at 77°C (170°F). The chromosulfuric acid bath had a composition such as:

| Component | Percentage in Mixture (Weight Percent) |
|---|---|
| 96% $H_2SO_4$ | 55.9 |
| 85—87% $H_3PO_4$ | 10.4 |
| $CrO_3$ | 3.0 |
| $H_2O$ | 30.7 |

Following the etchant, the board was plated with copper by an additive process which consists of chemically sensitizing the substrate, photographically imaging the circuitry, developing the image and plating electroless copper to form the electrically conductive network.

Finished boards were then soldered using conventional wave soldering equipment at several speeds using commercial water soluble and Freon based solder fluxes. Boards molded from the material in Example 10 were solderable at temperatures as high as 257°C (495°F) while those molded from the material in Control G were not solderable above 238°C (460°F), since above these temperatures the copper separated from the substrate surface resulting in failure.

Example 12

Materials of Controls A, B and C, and Examples 1, 2 and 3 were compression molded in a 0.5 mm 10.16 × 10.16 cm (20 mil 4 × 4 inch) cavity mold at 300°C into films 0.5 mm (20 mils) thick. Their 1 percent secant moduli were measured according to a procedure similar to ASTM D-638 between 25 and 250°C. As the temperature rose the moduli of the materials decreased. The temperatures at which the moduli decreased to 6896 kPa 1000 psi) are shown in Figure 1. If the composition contains between 40 and 90 weight percent of poly(ethersulfone), much higher temperatures can be reached with the modulus above 6896 kPa (1000 psi) as compared with those that can be reached with the polysulfone of Control A.

## Claims

1. Use of a composition comprising from 40 to 90 weight percent of a poly(ether sulfone) having repeating units of the following formula :

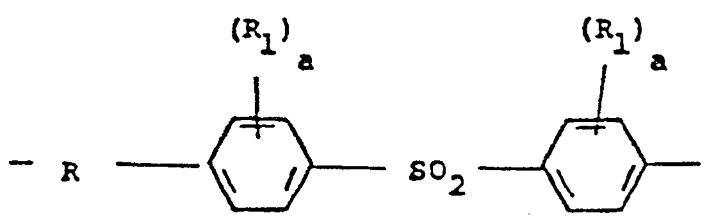

and from 10 to 60 weight percent of a polysulfone having repeating units of the following formula :

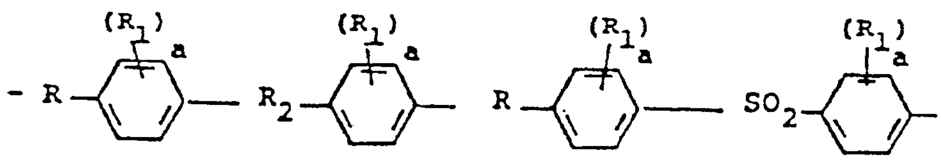

wherein R is selected form O and S, each $R_1$ is independently hydrogen,a halogen atom, an alkyl group of from 1 to 4 carbon atoms and an alkoxy group of from 1 to 4 carbon atoms, a is an integer of 0 to 4 and $R_2$ is a bond between aromatic carbon atoms or a divalent connecting radical of the formula :

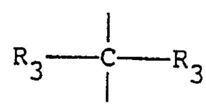

wherein $R_3$ is independently selected from $C_1$-$C_4$-alkyl, aryl and halogen substituted groups thereof ; for making circuit board substrates and electrical connectors.

2. Use of a composition as defined in claim 1 wherein the poly (ether sulfone) has repeating units of the following formula :

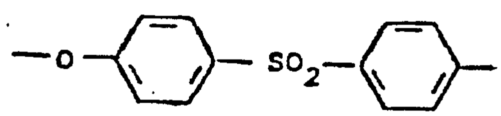

3. Use of a composition as defined in claim 1 wherein the poly(ether sulfone) contains units of the formula:

(I) 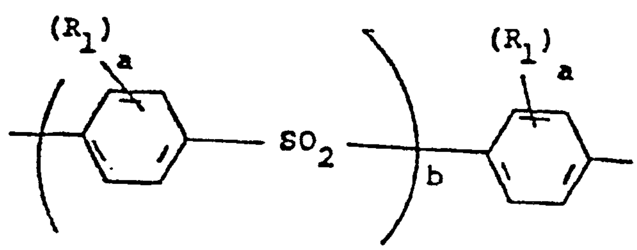 and

(II) 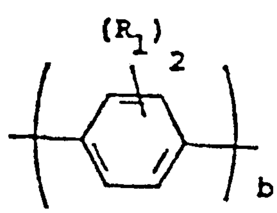

wherein b is independently an integer of 1 to 3, units (I) and (II) being attached to each other by an –O– bond.

4. Use of a composition as defined in claim 3 wherein the poly(ether sulfone) contains units of the formula:

(I) 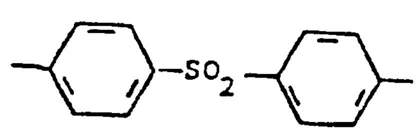 ; and

(II) 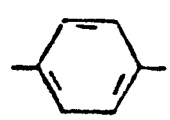

5. Use of a composition as defined in one or more of the claims 3 to 4 wherein the ratio of (I) to (II) is greater than 1.

6. Use of a composition as defined in one or more of the claims 1-5 wherein the polysulfone has repeating units of the formula :

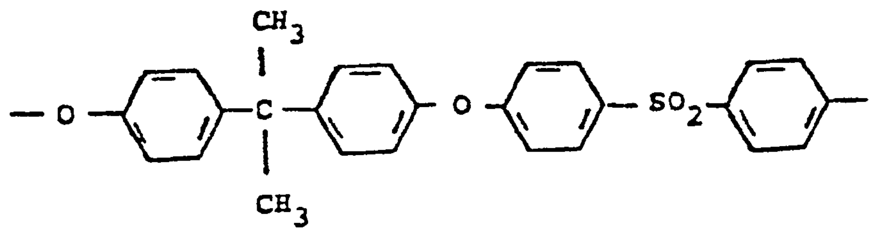

7. Use of a composition as defined in one or more of the claims 1 to 6 which contains a reinforcing fiber and/or a particulate inorganic filler.

8. Use of a composition as defined in claim 7 wherein the fiber is fiberglass and/or the filler is wollastonite.

9. A circuit board substrate comprising from 40 to 90 weight percent of a poly(ether sulfone) having repeating units of the following formula :

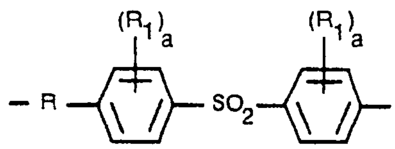

and from 10 to 60 weight percent of a polysulfone having repeating units of the following formula :

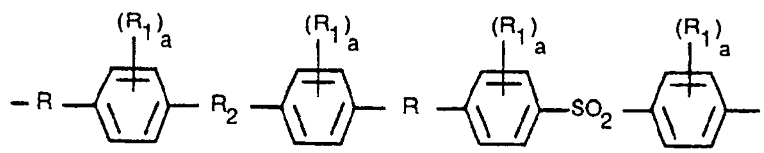

wherein R is selected from O and S and each R, independently hydrogen, a halogen atom, an alkyl group of from 1 to 4 carbon atoms and an alkoxy group of from 1 to 4 carbon atoms, a is an integer of 0 to 4 and $R_2$ is a bond between aromatic carbon atoms or a divalent connecting radical of the formula :

$$R_3—C—R_3$$

wherein $R_3$ is independently selected from C,-C,-alkyl, aryl and halogen substituted groups thereof.

10. The circuit board of Claim 9 having a copper electrical circuit firmly adhered thereto.

## Ansprüche

1. Verwendung einer Zusammensetzung umfassend 40 bis 90 Gew.-% eines Poly-(ethersulfons) mit wiederkehrenden Einheiten der folsenden Formel

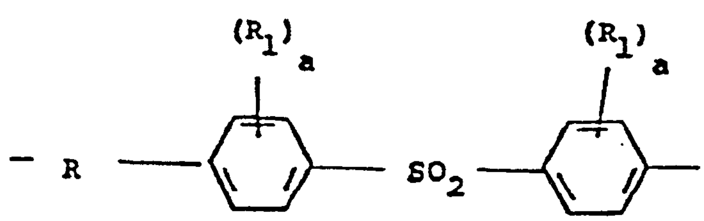

und 10 bis 60 Gew.-% eines Polysulfons mit wiederkehrenden Einheiten der folgenden Formel

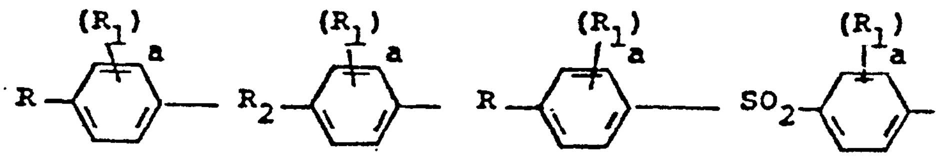

worin R ausgewählt ist von O und S, jedes $R_1$ unabhängig Wasserstoff, ein Halogenatom, eine Alkylgruppe mit 1 bis 4 Kohlenstoffatomen und eine Alkoxygruppe mit 1 bis 4 Kohlenstoffatomen ist, a eine ganze Zahl von 0 bis 4 ist und $R_2$ eine Bindung zwischen aromatischen Kohlenstoffatomen oder ein zweiwertiger verbindender Rest der Formel

$$R_3 - \overset{|}{\underset{|}{C}} - R_3$$

ist, worin $R_3$ unabhängig ausgewahlt ist aus $C_{1-4}$ Alkyl, aryl und halogensubstituierten Gruppen derselben, zur Herstellung von Substraten für elektrische Platinen und und elektrische Anschlußelemente.

2. Verwendung einer Zusammensetzung nach Anspuch 1, worin das Poly- (ethersulfon) wiederkehrende Einheiten der folgenden Formel hat :

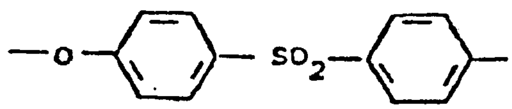

3. Verwendung einer Zusammensetzung nach Anspuch 1, worin das Poly-(ether-sulfon) Einheiten der Formel

(I) 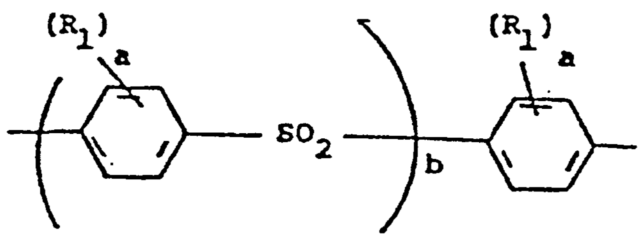 und

(II) 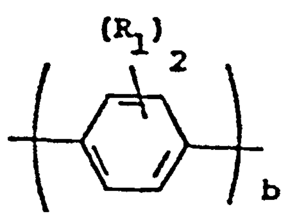

enthält, worin b unabhängig eine ganze Zahl von 1 bis 3 ist, wobei die Einheiten (I) und (II) durch eine –O– Bindung miteinander verbunden sind.

4. Verwendung einer Zusammensetzung nach Anspruch 3, worin das Poly-(ether-sulfon) Einheiten der Formel

(I) 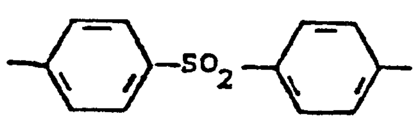 und (II) 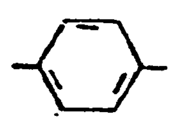

enthält.

5. Verwendung einer Zusammensetzung nach einem oder mehreren der Ansprüche 3 und 4, worin das

Verhältnis von (I) zu (II) größer als 1 ist.

6. Verwendung einer Zusammensetzung nach einem oder mehrere der Ansprüche 1 bis 5, worin das Polysulfon wiederkehrende Einheiten der Formel

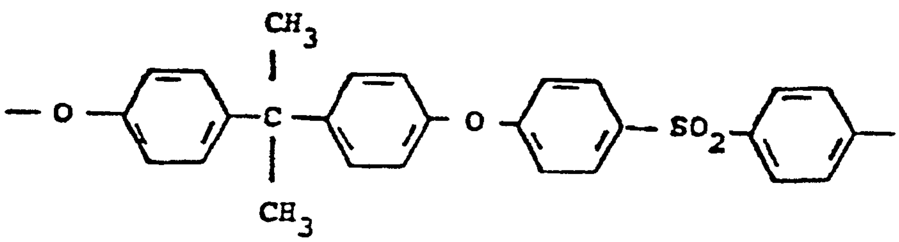

hat.

7. Verwendung eier Zusammensetzung nach einem oder mehreren der Ansprüche 1 bis 6, die eine verstärkende Faser und/oder einen feinteiligen anorganischen Füllstoff enthält.

8. Verwendung einer Zusammensetzung nach Anpruch 7, in welcher die Faser Glasfaser und/oder der Füllstoff Wollastonit ist.

9. Platinensubstrat, umfassend 40 bis 90 Gew.-% eines Poly-(ethersulfons) mit wiederkehrenden Einheiten der folgenden Formel

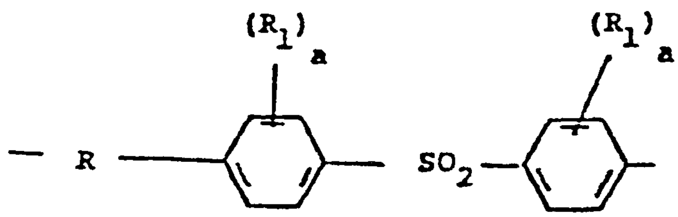

und 10 bis 60 Gew.-% eines Polysulfons mit wiederkehrenden Einheiten der folgenden Formel

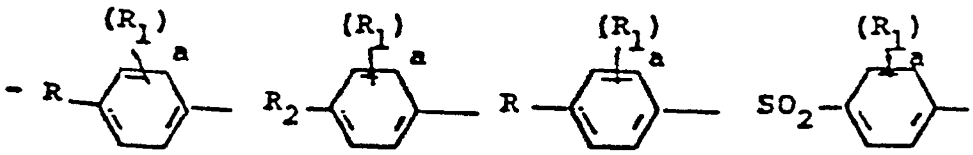

worin R ausgewählt ist von O und S und jedes $R_1$ unabhängig Wasserstoff, ein Halogenatom, eine Alkylgruppe mit 1 bis 4 Kohlenstoffatomen und eine Alkoxygruppe mit 1 bis 4 Kohlenstoffatomen ist, a eine ganze Zahl von 0 bis 4 ist und $R_2$ eine Bindung zwischen aromatischen Kohlenstoffatomen oder ein zweiwertiger verbindender Rest der Formel

$$R_3 - \overset{|}{\underset{|}{C}} - R_3$$

ist, worin $R_3$ unabhängig ausgewählt ist aus $C_{1-4}$ Alkyl, Aryl und halogensubstutierten Gruppen derselben.

10. Platine nach Anspruch 9 mit einer fest daran haftenden elektrischen Schaltung aus Kupfer.

## Revendications

1. Utilisation, pour fabriquer des substrats pour plaquettes de circuits et des connecteurs électriques, d'une composition comprenant 40 à 90% en poids d'une poly(éthersulfone) ayant des motifs répétés de formule suivante :

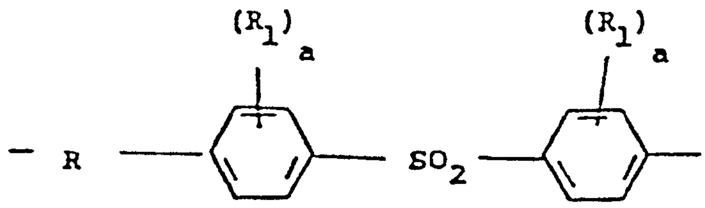

et 10 à 60% en poids d'une polysulfone portant des motifs répétés de formule suivante :

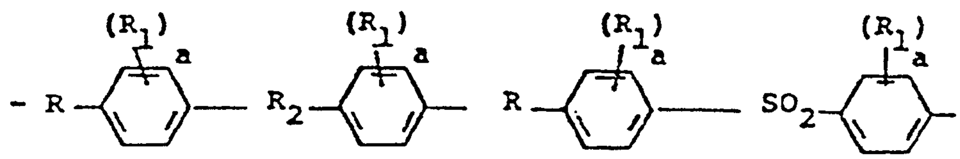

où R est choisi entre O et S, chaque groupe $R_1$ représente, indépendamment, l'hydrogène, un atome d'halogène, un groupe alkyle ayant 1 à 4 atomes de carbone et un groupe alkoxy ayant 1 à 4 atomes de carbone, a est un nombre entier de 0 à 4 et $R_2$ est une liaison entre des atomes aromatiques de carbone ou un radical divalent de jonction de formule :

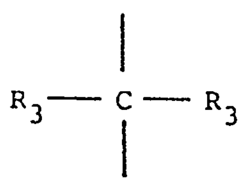

dans laquelle les groupes $R_3$ sont choisis, indépendamment, entre des groupes alkyle en $C_1$ à $C_4$, des groupes aryle et des groupes à substituants halogéno.

2. Utilisation d'une composition suivant la revendication 1, dans laquelle la poly(éthersulfone) porte des motifs répétés de formule suivante :

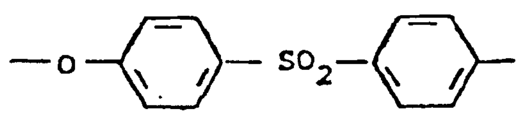

3. Utilisation d'une composition suivant la revendication 1, dans laquelle la poly(éthersulfone) contient des motifs de formule :

(I) 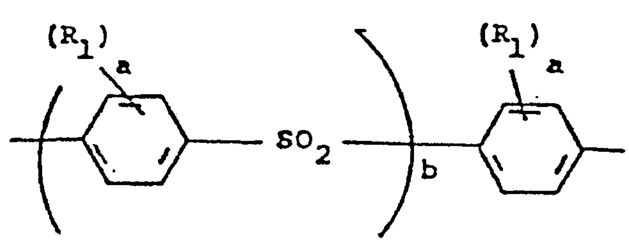 et

(II) 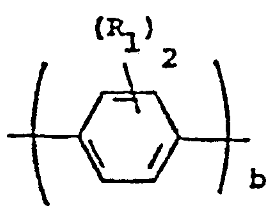

dans laquelle b représente, indépendamment, un nombre entier de 1 à 3, les motifs (I) et (II) étant attachés les uns aux autres par une liaison –O–

4. Utilisation d'une composition suivant la revendication 3, dans laquelle la poly(éthersulfone) contient des motifs de formule :

(I) 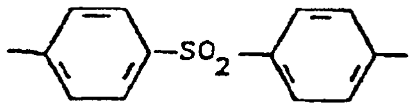 et

(II) 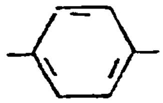

5. Utilisation d'une composition suivant une ou plusieurs des revendications 3-4, dans laquelle le rapport de (I) à (II) est supérieur à 1.

6. Utilisation d'une composition suivant une ou plusieurs des revendications 1-5, dans laquelle la polysulfone a des motifs répétés de formule :

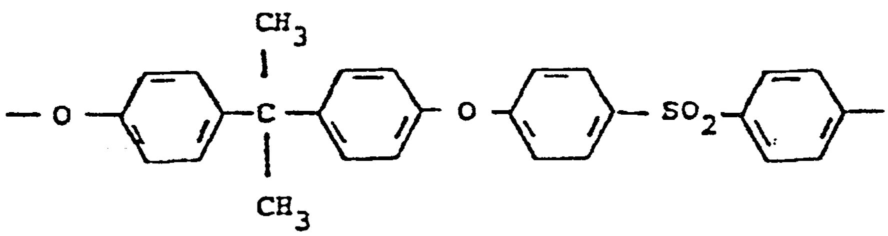

7. Utilisation d'une composition suivant une ou plusieurs des revendications 1-6, qui contient une fibre de renforcement et/ou une charge inorganique en particules.

8. Utilisation d'une composition suivant la revendication 7, dans laquelle la fibre est du verre en fibre et/ou la charge est de la wollastonite.

9. Substrat pour plaquette de circuit, comprenant 40 à 90% en poids d'une poly(éthersulfone) ayant des motifs répétés de formule suivante :

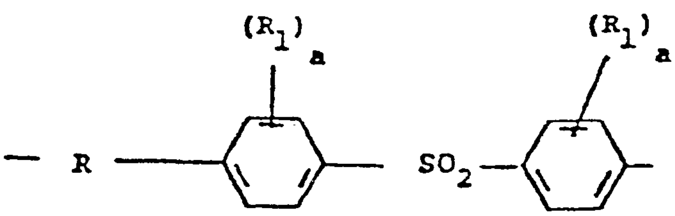

et 10 à 60% en poids d'une polysulfone ayant des motifs répétés de formule suivante :

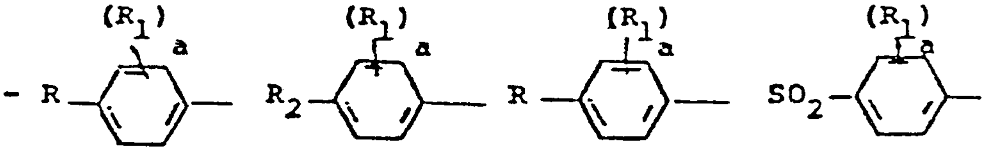

où R est choisi entre O et S et chaque groupe $R_1$ représente, indépendamment, l'hydrogène, un atome d'halogène, un groupe alkyle ayant 1 à 4 atomes de carbone et un groupe alkoxy ayant 1 à 4 atomes de carbone, a est un nombre entier de 0 à 4 et $R_2$ est une liaison entre des atomes aromatiques de carbone ou un radical divalent de jonction de formule :

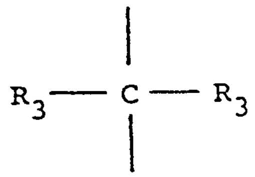

dans laquelle les groupes $R_3$ sont choisis, indépendamment, entre des groupes alkyle en $C_1$ à $C_4$, des groupes aryle et des groupes à substituants halogéno.

10. Plaquette de circuit suivant la revendication 9, à laquelle adhère solidement un circuit électrique en cuivre.

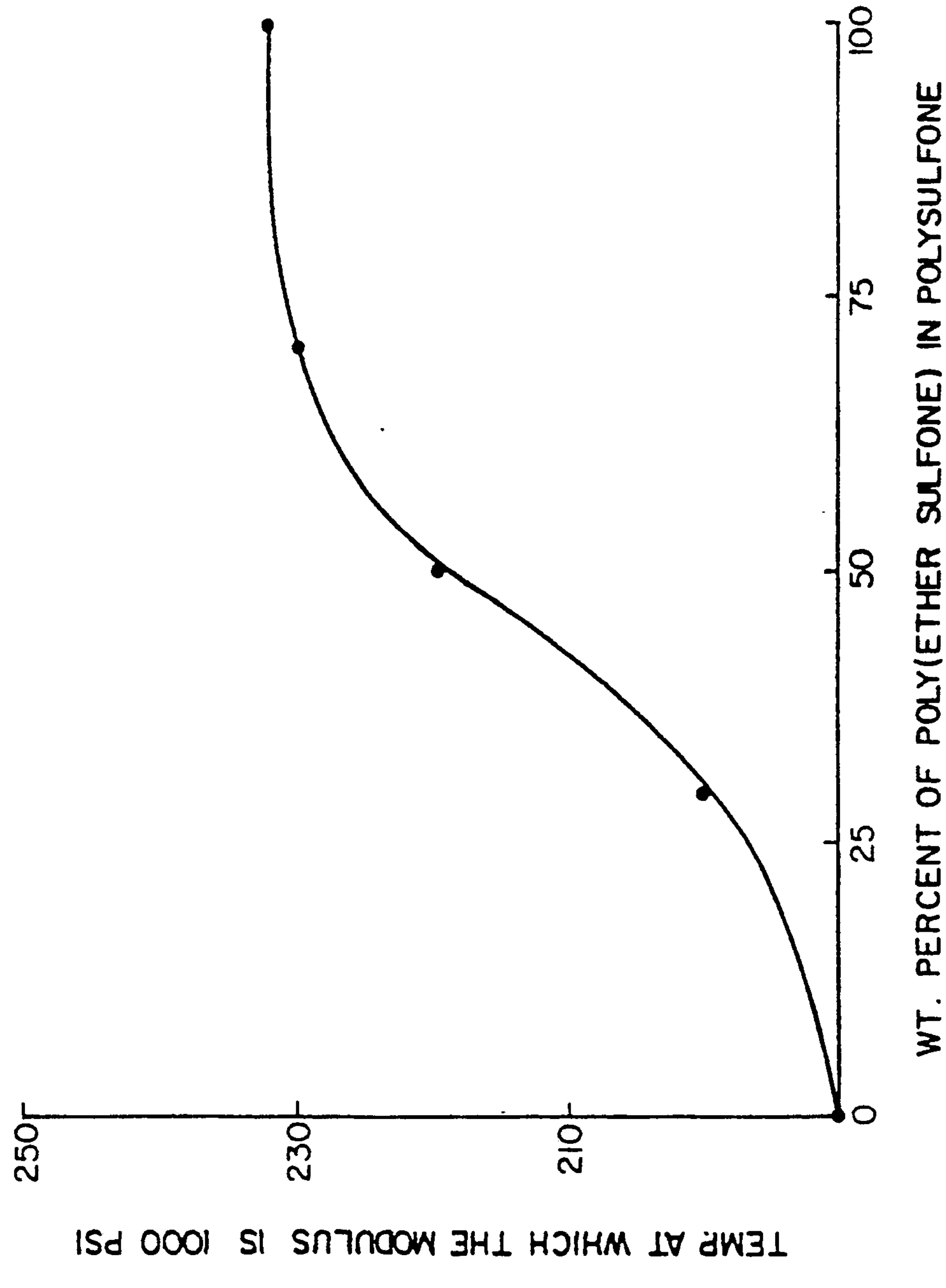

250
230
210
TEMP AT WHICH THE MODULUS IS 1000 PSI
0
25
50
75
100
WT. PERCENT OF POLY(ETHER SULFONE) IN POLYSULFONE